# EUROPEAN PATENT SPECIFICATION

(11) **EP 0 428 175 B1**
(45) Date of publication and mention of the grant of the patent: **15.06.1994**
(21) Application number: 90121916.2
(22) Date of filing: 15.11.1990
(51) Int. Cl.: G01P 15/12, G01P 15/08

(54) **Method of making a semiconductor sensor having funnel-shaped apertures in the semiconductor substrate**
Verfahren zur Herstellung eines Halbleitersensors mit trichterförmigen Öffnungen in dem Halbleitersubstrat
Procédé de fabrication d'un capteur semi-conducteur à ouvertures en forme d'entonnoir dans la couche semi-conductrice

(30) Priority: 15.11.1989 JP 296728/89
(43) Date of publication of application: 22.05.1991
(73) Proprietor: KABUSHIKI KAISHA TOSHIBA, Kawasaki-shi, Kanagawa-ken 210 (JP)
(72) Inventor: Hirano, Hirokazu, c/o Intellectual Property Div., Minato-ku, Tokyo 105 (JP); Yamaki, Bunshiro, c/o Intellectual Property Div., Minato-ku, Tokyo 105 (JP)
(74) Representative: Lehn, Werner, Dipl.-Ing.

(56) References cited:
- EP-A- 0 178 662
- US-A- 3 888 708
- IBM TECHNICAL DISCLOSURE BULLETIN, vol. 25, no. 10, March 1983, New York,US, pages 5041-5042; Speidell: "Silicon ion-beam extraction grids"

## Description

The present invention relates to a method of making a semiconductor sensor such as semiconductor acceleration sensors, semiconductor flow sensors and semiconductor micro-valves.

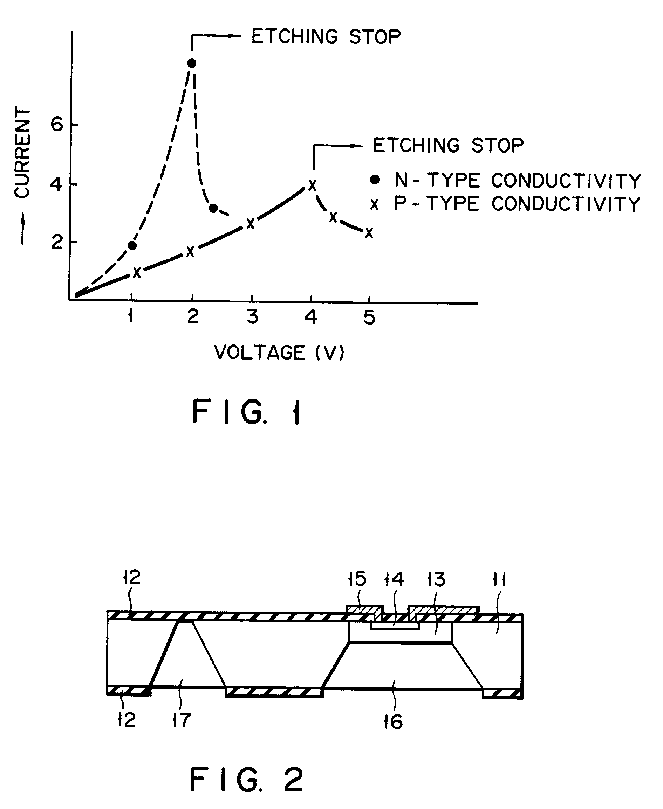

In semiconductor sensors such as semiconductor acceleration sensors, semiconductor flow sensors and semiconductor micro-valves, a silicon semiconductor substrate is selectively etched to provide a thin portion or a penetrating aperture therein. As a technique of etching such a silicon semiconductor substrate, there has been employed an electrolytic etching method using caustic potash, which utilizes a difference in electrolytic potentials due to the conductivity types of the semiconductor substrate. Fig. 1 shows etching characteristics obtained when N-type and P-type silicon semiconductor substrates having a (100) plane are electrolytically etched using the caustic potash. In Fig. 1, the ordinate indicates the electric current, and the abscissa the voltage, respectively. As is apparent from Fig. 1, in the case of the N-type semiconductor, the etching proceeds until the voltage reaches about 2 V. When the voltage exceeds 2 V, the etching is stopped. On the other hand, in the case of the P-type semiconductor, the etching proceeds until the voltage rises to about 4 V, but the etching stops when the voltage exceeds 4 V. Thus, if the voltage is set at 3 V, the N-type semiconductor is not etched, while the P-type semiconductor is etched.

By means of this anisotropic etching, the thin portion or penetrating aperture is formed in the silicon semiconductor substrate, thus providing a semiconductor sensor. Fig. 2 shows a structure of a conventional semiconductor acceleration sensor, which comprises a P-type silicon semiconductor substrate 11, an N-type semiconductor region 13 serving as a thin portion (diaphragm) and formed in a major surface of the P-type semiconductor substrate 11, a P-type semiconductor region 14 serving as a resistor and formed in the N-type semiconductor region 13, an electrode wiring layer 15 formed on the P-type semiconductor region 14 through an insulating layer 12, a funnel-shaped cavity 16 made from the bottom surface of the semiconductor substrate 11 to form the thin portion, and a funnel-shaped aperture 17 penetrating in the thickness direction of the substrate 11 so as to surround both side surfaces of the thin portion.

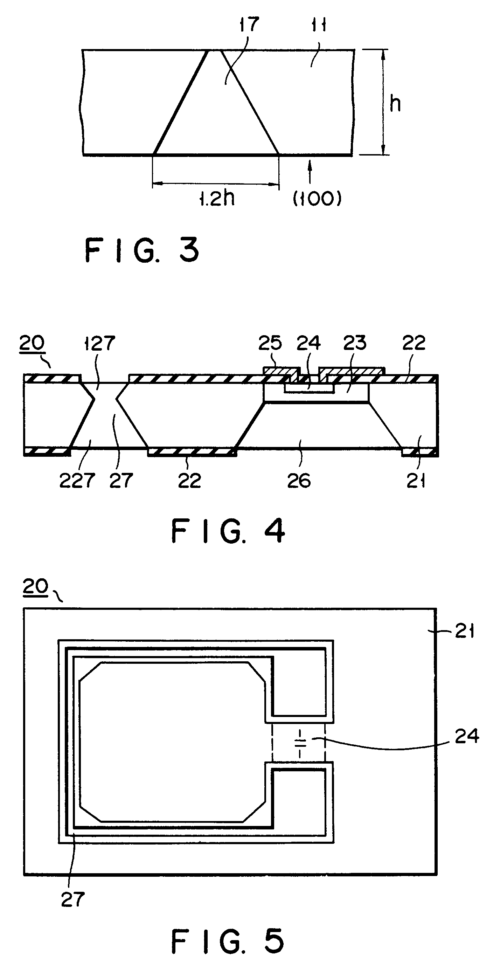

The funnel-shaped aperture 17 is formed by etching the bottom surface of the semiconductor substrate 11 so as to penetrate the substrate 11. The angle between the bottom surface of the semiconductor substrate 11 and the wall defining the aperture 17 is about 60°. Thus, as is shown in Fig. 3, when the thickness of the semiconductor substrate 11 is given by h, the diameter of the funnel-shaped aperture 17 becomes 1.2 h. As a result, it is not possible to reduce the size of the semiconductor sensor.

From EP-A-0178 662 a method of manufacturing a semiconductor accelerometer having a cantilevered beam is known. According to this method a semiconductor substrate is divided into p-type regions and n-type regions and the substrate is immersed into an electrochemical solution with a cathode in a condition that a voltage is applied between the electrode and the cathode to carry out an electrochemical etching. In this way a certain portion of the substrate is protected from the etching by the voltage.

It is the object of the present invention, to provide a method of making a semiconductor sensor, wherein a funnel-shaped penetrating aperture and a diaphragm are simultaneously formed.

According to the present invention this object is solved by a method of making a semiconductor sensor having a diaphragm in a semiconductor substrate,
characterized by comprising:
a) preparing a P-type semiconductor substrate having first and second surfaces;
b) forming an N-type semiconductor region, acting as a diaphragm, in the semiconductor substrate;
c) forming at least one of P-type semiconductor elements in the N-type semiconductor region;
d) subjecting the semiconductor substrate to electrolytic etching from the first surface so as to surround desired sides of the N-type semiconductor region, thereby forming a first funnel-shaped aperture in the semiconductor substrate; and
e) subjecting the semiconductor substrate to electrolytic etching from the second surface so as to reach the bottom of the N-type semiconductor region, thereby forming in the semiconductor substrate both a second funnel-shaped aperture communicating with the first funnel-shaped aperture, and a cavity at the same time.

There is provided a semiconductor sensor with a compact structure, which comprises a semiconductor substrate, a semiconductor diaphragm integrally formed with the semiconductor substrate, and a penetrating aperture formed in the semiconductor substrate so as to surround desired sides of the diaphragm. The aperture has a first funnel-shaped aperture and a second funnel-shaped aperture jointed to the first funnel-shaped aperture. A cavity for defining the diaphragm is provided when the semiconductor substrate is subjected to electrolytic etching to form the second funnel-shaped aperture therein.

The invention may best be understood by reference to the following description and accompanying drawings in which:
Fig. 1 is a graph showing etching characteristics obtained when a silicon semiconductor substrate is electrolytically etched, using an electrolytic etching solution of caustic potash;
Fig. 2 is a cross-sectional view showing a conventional semiconductor acceleration sensor;
Fig. 3 is an enlarged cross-sectional view showing a funnel-shaped penetrating aperture in the conventional semiconductor acceleration sensor;
Fig. 4 is an enlarged cross-sectional view showing a semiconductor acceleration sensor according to an embodiment of the present invention;
Fig. 5 is a plane view of the semiconductor acceleration sensor;
Figs. 6A to 6D are cross-sectional views illustrating a process of making the semiconductor acceleration sensor according to the embodiment of the invention;
Fig. 7 is an enlarged cross-sectional view showing a funnel-shaped penetrating aperture in the semiconductor acceleration sensor according to the embodiment of the invention; and
Figs. 8A to 8C are enlarged cross-sectional views showing various types of funnel-shaped penetrating apertures in the semiconductor sensors.

A semiconductor acceleration sensor according to an embodiment of the present invention will now be described with reference to Figs. 4 and 5.

A semiconductor acceleration sensor 20 includes a P-type silicon semiconductor substrate 21, an N-type semiconductor region 23 serving as a thin portion (diaphragm) formed in a major surface of the P-type semiconductor substrate 21, P-type semiconductor regions 24 formed in the N-type semiconductor region 23 and serving as resistor layers, electrode wiring layers 25 formed above the P-type semiconductor regions 24 through an insulating layer 22, and a funnel-shaped cavity 26 formed from the bottom surface of the semiconductor substrate 21 and defining the thin portion. A funnel-shaped aperture 27 penetrating the substrate 21 in the thickness direction so as to surround the thin portion includes an upper aperture 127 formed from the top surface of the semiconductor substrate 21 and a lower aperture 227 formed from the bottom surface of the substrate 21. As is shown in Fig. 5, in the semiconductor acceleration sensor 20, four P-type semiconductor regions 24 serving as resistor layers are provided in the N-type semiconductor region 23 serving as the diaphragm in order to provide a bridge circuit. Though not shown, bonding pads are formed at an end portion of the semiconductor substrate 21. The bonding pads are connected to end portions of the resistor layers 24 through the electrode wiring layers 25.

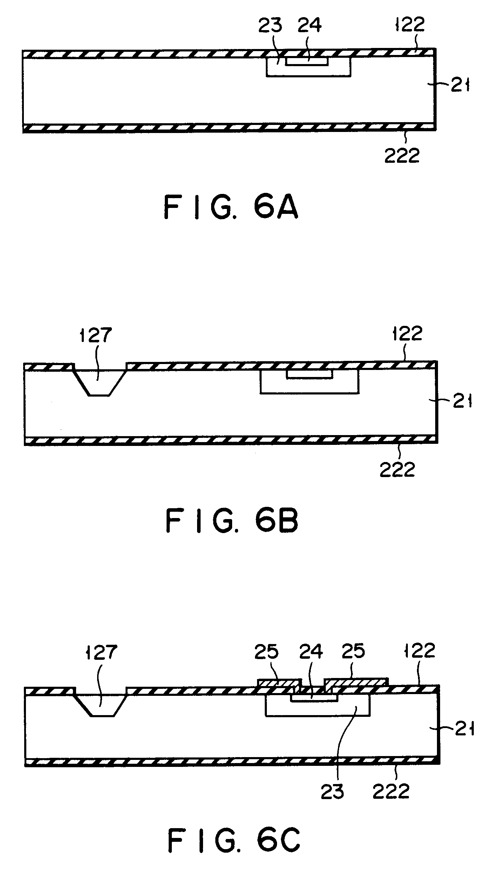

A method of making the semiconductor acceleration layer 20 will now be described with reference to Figs. 6A to 6D.

As is shown in Fig. 6A, a P-type silicon semiconductor substrate 21 having a thickness of 300 microns and having a (100) or (110) crystal plane is prepared. Oxide films 122 and 222 are formed on both surfaces of the semiconductor substrate 21. An N-type impurity is selectively introduced into the semiconductor substrate to provide an N-type semiconductor region 23 having a thickness of 60 to 80 microns therein. Then, a P-type impurity is introduced into the N-type semiconductor region 23, thereby forming a plurality of P-type semiconductor regions 24 serving as resistors. For example, each of the P-type semiconductor regions 24 has a depth of about 3 microns, a length of about 80 microns, and a width of about 20 microns.

As is shown in Fig. 6B, after an opening with a predetermined size is formed in the oxide film 122, electrolytic etching with use of an electrolyte of caustic potash is carried out to form an upper funnel-shaped aperture 127 in the substrate 21. In this case, the depth of the funnel-shaped aperture 127 is set so as to be equal to the thickness of the N-type semiconductor region 23.

Subsequently, as is shown in Fig. 6C, the oxide film 122 on the P-type semiconductor region 24 is selectively removed to provide electrode wiring layers 25 at both end portions of the P-type semiconductor region 24.

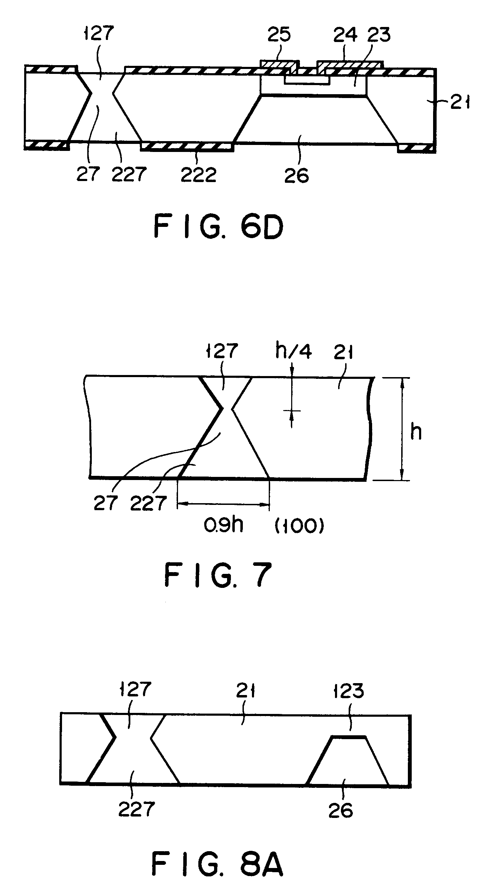

Then, as is shown in Fig. 6D, openings of predetermined sizes are made in the oxide film 222 formed on the bottom surface of the semiconductor substrate 21 at positions corresponding to the funnel-shaped aperture 127 and the N-type semiconductor region 23. In the same manner as mentioned above, the exposed semiconductor substrate 21 is selectively removed by the electrolytic etching, thereby forming a lower funnel-shaped aperture 227 and a cavity 26 therein. In this case, the funnel-shaped apertures 127 and 227 are connected with each other, and a penetrating aperture 27 is formed. In addition, a diaphragm or a thin portion (corresponding to the N-type semiconductor region 23) is formed by the cavity 26. As a matter of course, in the described etching steps, the semiconductor substrate 21 is coated with an etching mask such as wax materials.

As is clear from Fig. 6D, the angle between the bottom surface of the semiconductor substrate 21 (having a length of about 6 mm) and the wall defining the aperture 227 is about 60°. The diameter of the opening of the aperture 127 is about 0.35 mm, that of the opening of the aperture 227 is about 0.5 mm, and that of the opening of the cavity 26 is about 1 mm, respectively.

Fig. 7 is an enlarged cross-sectional view showing the penetrating aperture 27 consisting of the funnel-shaped apertures 127 and 227 shown in Fig. 6D. When the depth of the aperture 127 is given by h/4 (h: the thickness of semiconductor substrate 21), the diameter of the opening of the funnel-shaped aperture 227 becomes 0.9 h. Thus, the size of the penetrating aperture 27 can be reduced, as compared with the prior art shown in Fig. 3 wherein only the bottom surface of the substrate is etched to form the funnel-shaped aperture.

The funnel-shaped apertures 127 and 227 formed at both side portions of the diaphragm serve as buffers against mechanical and thermal shock.

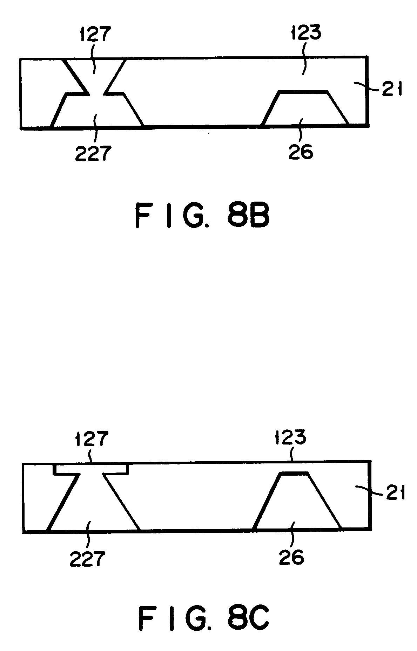

Furthermore, as is shown in Figs. 8A to 8C; penetrating apertures provided by upper and lower funnel-shaped apertures 127 and 227 having various configurations, which are different in the diameter and depth may be formed in the semiconductor substrate, and diaphragms having the different thickness, that is, the different depth may also be provided.

As has been described above, according to the present invention, since the penetrating aperture in the semiconductor substrate is provided by upper and lower funnel-shaped apertures which are formed from both surfaces of the substrate by means of etching, the size of the penetrating aperture can be reduced, and the lower funnel-shaped aperture and the cavity can be simultaneously formed with high precision. In addition, by changing the etching amount of the top and bottom surfaces of the substrate, the thickness of the diaphragm can be controlled. Therefore, high sensitivity semiconductor sensors with the small size can be obtained with a high yield.

It is further understood by those skilled in the art that the foregoing description is a preferred embodiment of the disclosed device and the method and that various changes and modifications may be made in the invention departing from the scope of the claims.

Reference signs in the claims are intended for better understanding and shall not limit the scope.

## Claims

1. A method of making a semiconductor sensor (20) having a diaphragm (23) in a semiconductor substrate,
characterized by comprising:
a) preparing a P-type semiconductor substrate (21) having first and second surfaces;
b) forming an N-type semiconductor region (23), acting as a diaphragm, in the semiconductor substrate (21);
c) forming at least one of P-type semiconductor elements (24) in the N-type semiconductor region (23);
d) subjecting the semiconductor substrate (21) to electrolytic etching from the first surface so as to surround desired sides of the N-type semiconductor region (23), thereby forming a first funnel-shaped aperture (127) in the semiconductor substrate (21); and
e) subjecting the semiconductor substrate (21) to electrolytic etching from the second surface so as to reach the bottom of the N-type semiconductor region (23), thereby forming in the semiconductor substrate (21) both a second funnel-shaped aperture (227) communicating with the first funnel-shaped aperture (127), and a cavity (26) at the same time.

2. The method according to claim 1,
characterized in that the depth of the first funnel-shaped aperture (127) is substantially equal to that of the N-type semiconductor region (23).

3. The method according to claim 1,
characterized in that the step (d) is carried out in such a manner that the depth of the first funnel-shaped aperture (127) is given by h/4 where h is the thickness of the semiconductor substrate (21).

4. The method according to claim 3,
characterized in that the diameter of the second funnel-shaped aperture (227) is given by 0.9h.

## Patentansprüche

1. Verfahren zum Herstellen eines Halbleitersensors (20) mit einem Diaphragma (23) in einem Halbleitersubstrat,
gekennzeichnet durch die Schritte:
a) Bereiten eines P-Typ Halbleitersubstrats (21) mit einer ersten und zweiten Oberfläche;
b) Bilden eines N-Typ Halbleiterbereichs (23), dienend als ein Diaphragma, in dem Halbleitersubstrat (21);
c) Bilden zumindest eines von P-Typ Halbleiterelementen (24) in dem N-Typ Halbleiterbereich (23;
d) Unterwerfen des Halbleitersubstrats (21) elektrolytischem Ätzen von der ersten Oberfläche, um somit erwünschte Seiten des N-Typ Halbleiterbereichs (23) zu umgeben, und dadurch eine erste trichterförmige Öffnung (127) in dem Halbleitersubstrat (21) zu bilden; und
e) Unterwerfen des Halbleitersubstrats (21) elektrolytischem Ätzen von der zweiten Oberfläche, um somit den Boden des N-Typ Halbleitersubstrats zu erreichen, und dadurch in dem Halbleitersubstrat (21) sowohl eine zweite trichterförmige Öffnung (227), kommunizierend mit der ersten trichterförmigen Öffnung (127), als auch eine Aushöhlung (26) zur selben Zeit zu bilden.

2. Verfahren nach Anspruch 1, dadurch gekennzeichnet, daß die Tiefe der ersten trichterförmigen Öffnung (127) im wesentlichen gleich der des N-Typ Halbleiterbereichs (23) ist.

3. Verfahren nach Anspruch 1, dadurch gekennzeichnet, daß der Schritt (d) auf solche Art und Weise ausgeführt wird, daß die Tiefe der ersten trichterförmigen Öffnung (127) gegeben ist durch h/4, wobei h die Dicke des Halbleitersubstrats (21) ist.

4. Verfahren nach Anspruch 3, dadurch gekennzeichnet, daß der Durchmesser der zweiten trichterförmigen Öffnungen (227) durch 0,9 h gegeben ist.

## Revendications

1. Procédé de fabrication d'un capteur à semi-conducteur (20) possédant un diaphragme (23) dans un support de semi-conducteur, procédé caractérisé par le fait qu'il comprend :
a) la préparation d'un support de semi-conducteur de type P (21) possédant des première et seconde surfaces;
b) la formation d'une zone de semi-conducteur de type N (23) agissant comme diaphragme dans le support de semi-conducteur (21);
c) la formation d'au moins un des éléments de semi-conducteur de type P (24) dans la zone de semi-conducteur de type N (23);
d) la soumission du support de semi-conducteur (21) à une attaque chimique par électrolyse à partir de la première surface de façon à détourer des côtés désirés de la zone de semi-conducteur de type N (23), formant ainsi une première ouverture en forme d'entonnoir (127) dans le support de semi-conducteur (21); et
e) la soumission du support de semi-conducteur (21) à une attaque chimique par électrolyse à partir de la seconde surface de façon à atteindre le fond de la zone de semi-conducteur de type N (23), formant ainsi dans le support de semi-conducteur (21), à la fois, une seconde ouverture en forme d'entonnoir (227) communiquant avec la première ouverture en forme d'entonnoir (127) et une cavité (26) en même temps.

2. Procédé selon la revendication 1, caractérisé en ce que la profondeur de la première ouverture en forme d'entonnoir (127) est pratiquement égale à celle de la zone de semi-conducteur de type M (23).

3. Procédé selon la revendication 1, caractérisé en ce que l'étape d) est effectuée de telle façon que la profondeur de la première ouverture en forme d'entonnoir (127) soit donnée par h/4 où h est l'épaisseur du support de semi-conducteur (21).

4. Procédé selon la revendication 3, caractérisé en ce que le diamètre de la seconde ouverture en forme d'entonnoir (227) est donnée par 0,9 h.
